(19) Europäisches Patentamt / European Patent Office / Office européen des brevets

(11) **EP 1 641 040 B1**

(12) **EUROPEAN PATENT SPECIFICATION**

(45) Date of publication and mention
of the grant of the patent:
**07.11.2018 Bulletin 2018/45**

(51) Int Cl.:
*H01L 23/373* (2006.01)    *H01L 21/48* (2006.01)

(21) Application number: **05020238.1**

(22) Date of filing: **16.09.2005**

(54) **Thermally conductive sheet and method for producing the same**

Thermisch leitfähige Folie und deren Herstellungsmethode

Feuille thermoconductrice et son procédé de fabrication

(84) Designated Contracting States:
**DE FR**

(30) Priority: **22.09.2004 JP 2004275968**

(43) Date of publication of application:
**29.03.2006 Bulletin 2006/13**

(73) Proprietor: **Fuji Polymer Industries Co., Ltd.
Nagoya-shi, Aichi 460-0012 (JP)**

(72) Inventor: **Funahashi, Hajime
Nishikamo-gun
Aichi 470-0533 (JP)**

(74) Representative: **Isarpatent
Patent- und Rechtsanwälte Behnisch Barth
Charles
Hassa Peckmann & Partner mbB
Postfach 44 01 51
80750 München (DE)**

(56) References cited:
| | |
|---|---|
| EP-A- 1 067 164 | US-A- 4 685 987 |
| US-A- 6 090 484 | US-A1- 2002 012 762 |
| US-A1- 2002 135 984 | US-B1- 6 644 395 |
| US-B1- 6 657 297 | US-H- H1 699 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to thermally conductive sheets that are used when mounting electronic components generating a large amount of heat to the cooling portions of heat sinks, radiators and the like, and to methods for producing such thermally conductive sheets.

Thermally conductive materials are used when mounting electronic components generating a large amount of heat, such as power transistors and power modules (hereinafter, referred to as "heat-generating electronic components"), to heat sinks, radiators and the like for eliminating gaps between the components and conducting the heat that is generated by the heat-generating electronic components to the heat sinks, the radiators and the like efficiently. As such thermally conductive materials, there have been proposed, for example, heat-radiating grease and heat-radiating compounds that are formed by mixing liquid silicone with a metal oxide, and thermally conductive heat-radiating members that are fabricated by mixing silicone rubber with a metal oxide and molding it into a sheet (JP H9-207275A and JP H10-183110A).

However, the use of grease, compounds and heat-radiating sheets that are made of liquid silicone resin and silicone rubber has been avoided recently, since low molecular weight siloxane is volatilized when the heat-radiating members are heated by the heat that is generated by operating the heat-generating electronic components, and the low molecular weight volatile silicone that is filled inside the electronic devices tends to cause a so-called "silicone trouble". Therefore, heat-radiating members that are made of materials other than silicone increasingly have been used recently.

US-B-6644395 describes a layer of a pressure-sensitive adhesive disposed on a surface of the thermally conductive material. The thermally conductive material layer is self-supporting and formulated as a blend of a cured polymeric binder and a thermally conductive filler.

US-A-6090484 describes a laminate comprising a thermally conductive layer having an adhesive film bonded thereto.

US-B-6657297 describes a skin layer, which permits it to be applied as a hot-melt of flexible film.

Therefore, with the foregoing in mind, it is an object of the present invention to provide a thermally conductive sheet having high thermal conductivity, good dimensional stability, softness, excellent loading characteristics and resistance to cracking, by using a polymer compound that does not create the possibility that a low molecular weight substance such as a monomer or an oligomer will bleed out, and a method for producing the thermally conductive sheet.

A thermally conductive sheet according to the present invention is a thermally conductive sheet including, as a main component, an acrylic polymer into which a thermally conductive filler is mixed, wherein an inner layer or one side of the sheet is a solventless, adhesive elastic product, and a cured thin film layer is formed integrally with a surface layer portion on at least one selected from top and bottom surfaces of the sheet, and a sheet-like reinforcing material is further embedded in the surface layer portion on said one of the top and bottom surfaces of the sheet, characterized in that: the thermally conductive sheet has a thickness in the range from 0.10 to 10 mm, and the cured thin film layer has a thickness in the range from 0.001 to 0.50 mm, and a portion of the sheet that constitutes the inner layer or one side has a viscosity in the range from $1 \times 10$ to $3 \times 10^3$ Pa. s ($1 \times 10^4$ to $3 \times 10^6$ cP), and in the thermally conductive sheet, the thermally conductive filler in the range from 50 to 3000 g (50 to 3000 parts by mass) per 100 g (100 parts by mass) of the acrylic polymer is mixed, and the thermally conductive sheet has a thermal conductivity of 0.5 to 5.0 W/m K, and the thermally conductive, cured thin film layer has a thermal conductivity of 0.20 to 2.5 W/m K, and the main component acrylic polymer into which the thermally conductive filler is mixed has an ASKER C hardness in the range from 5 to 95, after curing the sheet, and the sheet-like reinforcing material is embedded at a depth in the range from more than 0 mm to 1.00 mm from the surface, and the sheet has a thickness of 0.10 mm to 10.0 mm.

A method for producing a thermally conductive sheet according to the present invention is a method for producing a thermally conductive sheet including, as a main component, an acrylic polymer into which a thermally conductive filler is mixed, the method including the steps of forming a cured thin film material layer wherein a material for a thermally conductive, cured thin film layer is applied uniformly as a thin film onto a surface of at least one selected from a top release film and a bottom release film; providing, when one of the films includes the cured thin film material layer, a release film as the other film; supplying, between the top film and the bottom film, a sheet base material including, as a main component, an acrylic polymer into which a thermally conductive filler is mixed, and molding the sheet base material into a sheet having a predetermined thickness; and thereafter curing only a surface layer portion of the sheet and then removing the films, thereby producing a thermally conductive sheet wherein an inner layer or one side of the sheet is a solventless, adhesive elastic product, and a cured thin film layer is formed integrally with a surface layer portion on at least one selected from the top and bottom surfaces of the sheet.

FIG. 1A is a cross-sectional view showing an embodiment of a thermally conductive sheet according to the present invention, and shows an example in which a cured thin film layer is formed on one side of a solventless, adhesive elastic product layer.

FIG. 1B shows an example in which the cured thin film layer is formed on both sides of the adhesive elastic product layer.

FIG. 2A is a cross-sectional view showing a thermally conductive sheet according to another embodiment of the present invention, and shows an example in which a sheet-like reinforcing material is embedded inside the surface of the solventless, adhesive elastic product layer, and the cured thin film layer is formed as the surface layer of the adhesive elastic product layer.

FIG. 2B shows an example in which the cured thin film layer is formed in both surfaces of the adhesive elastic product layer.

FIG. 3 is a plan view illustrating the method for measuring a thermal resistance value in the working examples and comparative examples of the present invention.

FIG. 4 is a cross-sectional side view illustrating the same method.

Hereinafter, the present invention will be described by way of illustrative embodiments with reference to the drawings.

The thermally conductive sheet of the present invention includes, as the main component, an acrylic polymer into which a thermally conductive filler is mixed. Here, "main component" refers to a component that constitutes at least 20 mass% of 100 mass% of the total organic components. Using an acrylic polymer as the base resin can eliminate the possibility that a low molecular weight substance such as a monomer or an oligomer will bleed out. This is a property inherent to acrylic polymers.

Furthermore, an inner layer or one side of the thermally conductive sheet of the present invention is a solventless, adhesive elastic product. It should be noted here that the term "solventless" as used herein means that the elastic product is formed without actively using an organic solvent. Thus, the elastic product may contain moisture in the air adsorbed thereto. Accordingly, when attaching the thermally conductive sheet to a heat-generating product such as an electronic component, the thermally conductive sheet freely can change its shape in the thickness direction so as to be attached to the heat-generating product without any gap, thus achieving high heat conductivity and high heat radiation. A cured thin film layer is formed integrally with a surface layer portion on at least one selected from the top and bottom surfaces of the sheet. Accordingly, while the inner layer or one side of the thermally conductive sheet is soft, like dough, the thermally conductive sheet is easy to handle because it has a hard thin film layer as the surface layer.

The method for producing a thermally conductive sheet according to the present invention provides a thermally conductive sheet of the present invention by attaching a thin layer of the material for a thermally conductive, cured thin film layer onto the surface layer of a soft sheet base material by using a so-called transfer method, and then curing only the surface layer of the above-described sheet. That is, the thermally conductive sheet is produced by applying the material for a thermally conductive, cured thin film layer uniformly as a thin film onto a release resin film, supplying, onto the surface on which the above-mentioned material has been applied, a sheet base material including, as the main component, an acrylic polymer into which a thermally conductive filler is mixed, placing the release resin film or the release resin film onto which the thermally conductive, cured thin film layer material is applied uniformly as a thin film, over the sheet base material, and molding the sheet base material into a sheet having a predetermined thickness, and thereafter curing only the surface layer portion of the above-described sheet, and then removing the above-described films.

According to the present invention, the cured thin film layer that is formed integrally with one or both sides of the thermally conductive sheet, or the thermally conductive, cured thin film layer has a thickness in the range from 0.001 mm to 0.50 mm. The thermally conductive sheet has an overall thickness of 0.10 mm to 10 mm. Furthermore, a sheet-like reinforcing material is embedded near the surface layer portion of one of the top and bottom surfaces, and it is preferable that the thickness of the thermally conductive sheet is larger than that of the sheet-like reinforcing material.

In the following, various materials and the manufacturing steps will be described.

(1) Thermally conductive sheet base material including, as the main component, an acrylic polymer into which thermally conductive filler is mixed.

As the acrylic polymer that is the main component of the thermally conductive sheet base material, it is preferable to use, for example, a single oligomer or polymer having at least two acrylic groups or methacrylic groups as the functional groups, a mixture of an oligomer and a monomer having at least two acrylic groups or methacrylic groups as the functional groups, a mixture of a polymer and a monomer having acrylic groups or methacrylic groups as the functional groups, or a mixture of a polymer, an oligomer and a monomer having at least two acrylic groups or methacrylic groups as the functional groups.

According to the present invention, the thermally conductive sheet base material is a mixture in which 50 g to 3000 g (50 parts by mass to 3000 parts by mass) of a thermally conductive substance per 100 g (100 parts by mass) of an acrylic polymer is mixed, and the filled amount of the thermally conductive substance is preferably 500 g to 2500 g (500 parts by mass to 2500 parts by mass). According to the present invention, the viscosity of the mixture is preferably in the range from 10 to 3000 Pa. s (10000 to 3000000 cP).

### (2) Thermally conductive filler

The thermally conductive filler that is mixed in the thermally conductive sheet base material of the present invention may be, for example, a powdered, fibrous, acicular, flakey or spherical filler that is made of one or more materials selected from the group consisting of metals such as aluminum, copper and silver, metal oxides such as alumina, magnesia and silica, and aluminum nitride, boron nitride, silicon nitride and the like. In the present invention, it is preferable to use metal oxides. The thermally conductive filler may be surface-treated with a known silane coupling agent that is selected in accordance with its properties. Furthermore, the above-described filler, when in the form of particles, preferably has an average particle size of 0.2 to 100 $\mu$m, and it is preferable that the size of the filler in other forms is in a range that is substantially equivalent to this particle size.

### (3) Material for cured thin film layer

The material for the cured thin film layer of the present invention may be an oligomer or a polymer that has at least two acrylic groups or methacrylic groups, and examples include urethane acrylate, epoxy acrylate and polyester acrylate. Commercially available products of these may be used suitably, either alone or as a mixture of two or more of them. The material for the cured thin film layer is solventless. The viscosity of the material is preferably 0.05 to 20 Pa. s (50 to 20000 cP), more preferably in the range from 1 to 10 Pa. s (1000 to 10000 cP).

### (4) Film provided with cured thin film layer

In the production of the cured thin film layer, the material for the cured thin film layer is applied uniformly as a thin film onto a resin film whose surface has been subjected to a mold release treatment in advance, by knife coating, bar coating, gravure coating or multistage roll coating, for example, thereby forming a film on the resin film.

### (5) Integration by transferring

In the present invention, it is preferable to use a method that includes filling a thermally conductive sheet base material into the surface film on which the material of a cured thin film layer is formed uniformly, removing the film after curing the base material, and integrating the cured thin film layer material with the surface of the thermally conductive sheet by transferring. Examples of the molding method include press molding, coating molding and calendaring molding, and any of these molding methods may be selected freely in accordance with the degree of viscosity of the compound.

### (6) Sheet-like reinforcing material

The sheet-like reinforcing material is contained in the inner layer of the thermally conductive sheet for reinforcing the sheet to prevent a significant deformation. Examples of the sheet-like reinforcing material include a woven or nonwoven fabric of, for example, plain weave, twill weave, satin weave, leno weave or mock leno weave of inorganic fiber such as glass fiber and carbon fiber, or synthetic resin fiber such as polyester fiber and nylon fiber. The sheet-like reinforcing material may be surface-treated with a known silane coupling agent that is selected in accordance with its properties. It is preferable that the sheet-like reinforcing material of the present invention is contained completely in the inner layer or one side of the thermally conductive sheet so as not to be exposed from the inner layer or one side. If the reinforcing material is exposed on the surface, then the surface of the thermally conductive sheet becomes uneven, leading to an insufficient adhesion between the heat-generating electronic components and a heat sink, a radiator or the like and thus causing gaps between the components. Accordingly, it is difficult to conduct the heat that is generated by the heat-generating electronic components to the heat sink, the radiator or the like efficiently.

### (7) Material for thermally conductive, cured thin film layer

The material for the thermally conductive, cured thin film layer according to a preferred embodiment of the present invention may be an oligomer or polymer that has at least two acrylic groups or methacrylic groups, and examples include urethane acrylate, epoxy acrylate and polyester acrylate. Commercially available products of these may be used suitably, either alone or as a mixture of two or more of them. Further, the thermally conductive substance that is mixed in the cured thin film layer may be, for example, a powdered, fibrous, acicular, flakey or spherical filler that is made of one or more materials selected from the group consisting of metals such as aluminum, copper and silver, metal oxides such as alumina, magnesia and silica, and aluminum nitride, boron nitride, silicon nitride and the like. In the present invention, the particle size of the metal oxides is preferably 0.2 to 8 $\mu$m. The thermally conductive substance may be surface-treated with a known silane coupling agent that is selected in accordance with its properties. The material for the cured thin film layer is solventless. The viscosity of the material is preferably 0.05 to 20 Pa. s (50 to 20000 cP), more preferably in the range from 1 to 10 Pa. s (1000 to 10000 cP).

(8) Film provided with thermally conductive, cured thin film layer

The thermally conductive, cured thin film layer is formed by applying the material for the thermally conductive cured thin film layer uniformly as a thin film onto a resin film that has been subjected to a mold release treatment, by knife coating, bar coating, gravure coating or multistage roll coating, for example, thereby forming a film on the resin film. Then, it is preferable to perform a method that includes filling, into a surface on which the material for the cured thin film layer is formed uniformly, a sheet base material including, as the main component, an acrylic polymer into which a thermally conductive filler is mixed, thereafter curing the mixture and then removing the film that has been subjected to a mold release treatment, and integrating the thermally conductive, cured thin film layer material with the surface of the thermally conductive sheet by transferring. Examples of the molding method include press molding, coating molding and calendaring, and any of these molding methods may be selected freely in accordance with the degree of viscosity of the compound. In any case, it is preferable to use, for example, a polyester film or a polypropylene film that has been surface-treated with a fluorine compound or a silicone compound, as the film on which the cured thin film layer is placed.

(9) Release film

The release film may be selected suitably from, for example, a polyester film, a polypropylene film and a fluorine film that have been surface-treated with a fluorine compound or a silicone compound.

(10) Protective film

It is preferable that the other side of the thermally conductive sheet that does not have the cured thin film layer is covered with, for example, an embossed protective film. An embossed film is a film whose surface is provided with protrusions and depressions. The density of the roughness may be adjusted appropriately in accordance with the difference in adhesive strength with the thermally conductive sheet. The protective film is like a sheet provided on a poultice. While any resin film may be used as the material for the protective film, it is preferable to use a film made of polyethylene resin or polypropylene resin having a thickness of about 30 $\mu$m to about 80 $\mu$m. It is preferable that the embossed surface has a level difference of at least 120 $\mu$m.

The present invention provides a thermally conductive sheet including, as the main component, an acrylic polymer into which a thermally conductive filler is mixed, wherein the inner surface or one side of the above-described sheet is a solventless, adhesive elastic product, and a cured thin film layer is formed integrally with the surface layer portion of at least one selected from the top and bottom surfaces of the above-described sheet. Accordingly, it is possible to provide a thermally conductive sheet that does not provide the possibility that a low molecular weight substance such as a monomer or an oligomer will bleed out, while having high thermal conductivity, good dimensional stability, softness, excellent loading characteristics and resistance to cracking, and a method for producing such a thermally conductive sheet. In addition, by molding a cured thin film layer that has been cured or embedding a sheet-like reinforcing material on the surface layer portion of at least one side of the thermally conductive sheet, the elongation of the product at the time of removal from a release sheet can be reduced significantly, resulting in better handleability. Moreover, by setting the ratio between a modified acrylate and an acrylic monomer, or the ratio between a modified acrylate and an acrylic polymer to a suitable ratio, the sheet will not crack when it is bent.

Embodiments

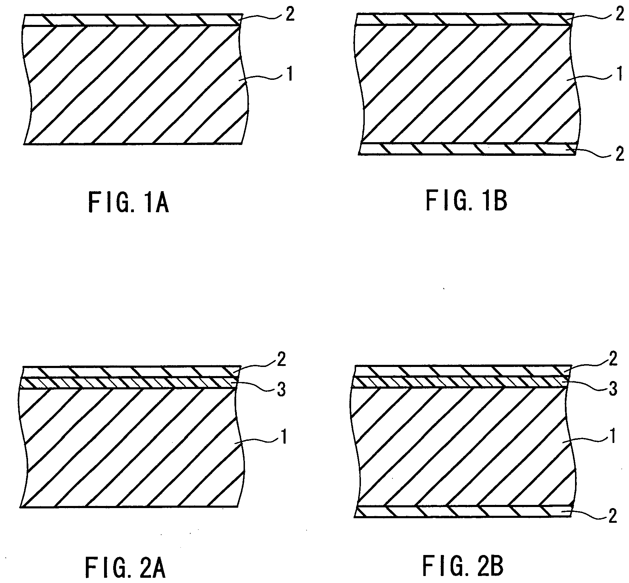

FIG. 1A is a cross-sectional view showing a thermally conductive sheet according to an embodiment of the present invention. As shown in FIG. 1A, the thermally conductive sheet includes a solventless, adhesive elastic product layer 1 including, as the main component, an acrylic polymer into which a thermally conductive filler is mixed, and a cured thin film layer 2 in which a thermally conductive filler is mixed. That is, the cured thin film layer 2 is formed on the surface layer portion of one side of the solventless, adhesive elastic product layer 1. FIG. 1B shows an example in which the cured thin film layer 2 is formed on the surface layer portion of both sides of the solventless, adhesive elastic product layer 1.

FIG. 2A is a cross-sectional view showing a thermally conductive sheet according to another embodiment of the present invention. As shown in FIG. 2A, the thermally conductive sheet includes a solventless, adhesive elastic product layer 1 including, as the main component, an acrylic polymer into which a thermally conductive filler is mixed, a sheet-like reinforcing material 3, and a cured thin film layer 2 that is provided as the surface layer of the sheet-like reinforcing material 3 and in which a thermally conductive filler is mixed. The sheet-like reinforcing material 3 is embedded in the solventless, adhesive elastic product layer 1.

FIG. 2B is a cross-sectional view showing a thermally conductive sheet according to yet another embodiment of the present invention. As shown in FIG. 2B, the thermally conductive sheet includes a solventless, adhesive elastic product layer 1 including, as the main component, an acrylic polymer into which a thermally conductive filler is mixed, a sheet-like reinforcing material 3, and a cured thin film layer 2 that is provided as the surface layer of the sheet-like reinforcing material 3 and in which a thermally conductive filler is mixed, and a cured thin film layer 2 that is provided on the back side of the solventless, adhesive elastic product layer 1. While a mesh structure made of, for example, polyester fiber, heat-resistant nylon fiber, aramid fiber or cotton fiber may be used as the sheet-like reinforcing material 3, it is preferable to use polyester fiber or heat-resistant nylon fiber from the view point of heat resistance.

<Measurement methods>

In the following, the measurement methods of various tests that were carried out in the working examples and comparative examples of the present invention will be described.

(1) Elongation

In this measurement, the elongation (degree of deformation) in the longitudinal direction of the sheet was measured. A test sheet having a thickness of 0.5 mm was half-cut precisely into a square shape with a length of 25 mm and a width of 25 mm on a release sheet (note here that "half-cut" means only the test sheet formed of a thermally conductive sheet is cut without cutting the release sheet), using a cutting machine. Then, the test sheet was removed by fingers from the release sheet to be collected, and its dimensions were measured precisely to determine the elongation of the test sheet.

(2) Hardness

A test sheet having a thickness of 3.0 mm was used, and the hardness of the test sheet was measured according to JIS-K7312 (Physical testing methods for molded products of thermosetting polyurethane elastomers).

(3) Load

"Load" as used herein refers to a compression force at which the sheet deforms when compressing the sheet. The purpose of measuring the load was to show the degree of deformation by compression of the sheet when the sheet included the cured thin film. A higher load indicates a higher resistance to deformation. In this measurement, a test sheet having a thickness of 3.0 mm was cut into a square shape with a length of 25 mm and a width of 25 mm, and the test sheet was then attached to the center of an aluminum plate (length: 27 mm, width: 27 mm, height: 3 mm) substantially accurately. Then, the test sheet was compressed using a MODEL 310N (compressing load measuring apparatus) manufactured by AIKOH Engineering Co. Ltd. that was provided with a load cell of 1960 N (200 Kgf) at a speed of 5 mm/min until the thickness of the test sheet became 50% of its original thickness, and the load was measured.

(4) Thermal resistance value in the thickness direction of the entire sheet

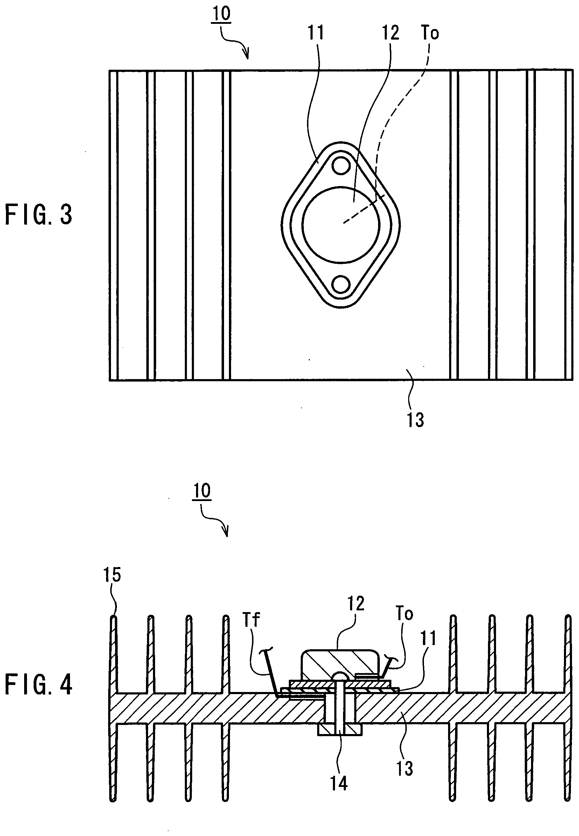

The thermal resistance value was measured using a test sheet having a thickness of 0.5 mm. A thermal resistance value measuring apparatus 10 as shown in FIG. 3 (plan view taken from the top) and FIG. 4 (cross-sectional side view) was used. First, a sample 11 that had been punched into a predetermined shape was prepared, and the sample 11 was inserted and attached between a transistor 12 and a radiator 13 (15 denotes heat-radiating fins). The sample 11 was attached by tightening a M3 screw 14 with a predetermined torque (5 kg-cm) using a torque driver. After attaching the sample 11, a DC voltage of 10 V and a current of 2 A (20 W) was applied to the transistor 12. Three minutes later, the transistor temperature To and the radiator temperature Tf were measured by temperature sensors provided at predetermined positions. Then, the thermal resistance value was calculated from the temperatures at the two points, using an equation. Specifically, the thermal resistance value was calculated using a transistor: 2SC2245 manufactured by FUJI ELECTRIC HOLDINGS CO., LTD., a radiator: 40CH104L-90-K manufactured by Ryosan Co., Ltd., and temperature sensors: 2SC1-OHK300 manufactured by CHINO CORPORATION, at ambient temperature and humidity: 25°C, 60% RH, by the following thermal resistance calculation equation:

$$\theta = (\mathrm{Tc} - \mathrm{Tf})/\mathrm{PC}$$

θ: thermal resistance value (°C/W)
Tc: transistor temperature (°C)
Tf: radiator temperature (°C)
PC: power applied to the transistor

(5) Method for evaluating the presence or absence of cracking

A test sheet having a thickness of 0.5 mm was wrapped around a metal rod having a diameter of 4 mm, and the presence or absence of cracking was evaluated by determining whether the test sheet cracked.

(6) Adhesive strength

The adhesive strength was measured according to JIS-Z-0237 (Testing methods of pressure-sensitive adhesive tapes and sheets).

(7) Removability

This test measured the removability of the sheet when the sheet was deformed by compression. A test sheet having a thickness of 3.00 mm was cut into a square shape with a length of 50 mm and a width of 50 mm, and the test sheet then was attached to the center of an aluminum plate (length: 55 mm, width: 55 mm, height: 3 mm) substantially accurately. Then, the test sheet was compressed using a MODEL 310N (compressing load measuring apparatus) manufactured by AIKOH Engineering Co. Ltd. that was provided with a load cell of 1960 N (200 Kgf) at a speed of 5 mm/min until the thickness of the test sheet became 50% (1.50 mm) of its original thickness. After releasing the load, the removability was evaluated by determining whether the aluminum plate could be removed manually.

In the following, the working examples and the comparative examples will be described. 1. Test-1 (Working Examples 1 to 4, Comparative Example 1) (1) Formation of thermally conductive sheet base material

100 g (100 parts by mass) of an acrylic polymer (product name: JDX-P1020 manufactured by JOHNSON POLYMER CORPORATION) and 20 g (20 parts by mass) of an acrylic monomer (product name: FA-511A manufactured by Hitachi Chemical Co., Ltd.) were kneaded in a mixer, together with 300 g (300 parts by mass) of aluminum oxide (product name: AS30 manufactured by SHOWA DENKO K.K.) and 2 g (2 parts by mass) of iron black, 1.0 g (1.0 part by mass) of a curing agent (chemical name: t-Amyl peroxy-2-ethylhexanoate manufactured by Kayaku Akzo Corporation), thereby forming a thermally conductive sheet base material. The thermal conductivity was 0.8 W/m-K.

(2) Formation of cured thin film layer

Urethane acrylate (product name: ARONIX M-1200 manufactured by Toagosei Co., Ltd.) as the material for the cured thin film layer was applied uniformly as a thin film with a thickness of 2 μm using a coating machine onto a polyester film with a thickness of 0.10 mm that had been subjected to a mold release treatment with fluorine, thereby forming a film provided with the cured thin film layer. Hereinafter, this film is referred to as "film 1".

(3) Release film

A polyester film having a thickness of 0.10 mm that had been surface-treated with a fluorine compound was used as the release film.

(4) Formation of sheet-like reinforcing material

The sheet-like reinforcing material was formed by cutting a polyester fiber mesh (product name: C33 A2-100E11 with a thickness of 0.16 mm, manufactured by UNITIKA GLASS FIBER CO., LTD.) into a predetermined size in such a manner that no grease or dirt would adhere onto the surface of the mesh.

Working Example 1

After placing the thermally conductive sheet base material on a sheet of the film 1, a sheet of the release film was placed on the sheet base material so as to form a sandwich structure. Thereafter, the whole structure was heated and pressure molded at 120°C for 30 minutes, thereby forming sheets (A1) with thicknesses of 0.5 mm and 3.0 mm, on one side of which the cured thin film layer was formed integrally.

Working Example 2

After placing the sheet-like reinforcing material on a sheet of the film 1, the thermally conductive sheet base material was placed on the reinforcing material, and a sheet of the release film was placed on the sheet base material so as to form a sandwich structure. Thereafter, the whole structure was heated and pressure molded at 120°C for 30 minutes, thereby forming sheets (A2) with thicknesses of 0.5 mm and 3.0 mm that contained the sheet-like reinforcing material and on one side of which the cured thin film layer was formed integrally.

Working Example 3

After placing the thermally conductive sheet base material on a sheet of the film 1, a sheet of the film 1 was placed on the sheet base material so as to form a sandwich structure. Thereafter, the whole structure was heated and pressure molded at 120°C for 30 minutes, thereby forming sheets (A3) with thicknesses of 0.5 mm and 3.0 mm, on both sides of which the cured thin film layer was formed integrally.

Working Example 4

After placing the sheet-like reinforcing material on a sheet of the film 1, the thermally conductive sheet base material was placed on the reinforcing material, and a sheet of the film 1 was placed on the sheet base material so as to form a sandwich structure. Thereafter, the whole structure was heated and pressure molded at 120°C for 30 minutes, thereby forming sheets (A4) with thicknesses of 0.5 mm and 3.0 mm that contained the sheet-like reinforcing material and on both sides of which the cured thin film layer was formed integrally.

Comparative Example 1

After placing the thermally conductive sheet base material on a sheet of the release film, a sheet of the same release film was placed on the sheet base material so as to form a sandwich structure. Thereafter, the whole structure was heated and pressure molded at 120°C for 30 minutes, thereby forming sheets (B1) with thicknesses of 0.5 mm and 3.0 mm.

Table 1 shows the results on the above-described sheets.

Table 1

| Sample No. | A1 | A2 | A3 | A4 | B1 |
|---|---|---|---|---|---|
| Cured thin film | one side only | one side only | both sides | both sides | not provided |
| Sheet-like reinforcing material | not provided | provided | not provided | provided | not provided |
| Elongation (mm) | 0 | 0 | 0 | 0 | 0.4 |
| Hardness (Asker C) | 25 | 37 | 32 | 40 | 20 |
| Load (N) (Kgf) | 392 (40) | 490 (50) | 490 (50) | (539) 55 | (245) 25 |
| Thermal resistance value (°C/W) | 0.84 | 0.81 | 0.90 | 0.93 | 0.80 |

As is clearly seen from Table 1, the sheets on the surface of which the cured thin film layer was formed integrally had good handleability. In addition, the elongation of the sheets at the time of removal from the release film could be reduced significantly by providing the reinforcing layer on the surface. Furthermore, when the cured thin film layer was formed from a mixture of a modified acrylate and an acrylic monomer, or a mixture of a modified acrylate and an acrylic polymer, the elongation of the sheet at the time of removal could be reduced to nearly "0". Additionally, the sheet did not crack when it was bent.

The elongation of the sheets of Working Examples 1 to 5 at the time of removal from the release film could be significantly lower than that of the sheet of Comparative Example 1, so the sheets of Working Examples 1 to 5 exhibited good handleability.

2. Test-2 (Working Examples 5 to 12, Comparative Example 2)

(1) Formation of thermally conductive sheet base material

The thermally conductive sheet base material was formed in the same manner as Test-1.

(2) Formation of film on which cured thin film layer was formed

In order to carry out the tests by using a variety of materials for the cured thin film layer that was formed integrally with the surface layer portion, film 2 to film 9 below were formed

<Film 2>

Urethane acrylate (product name: ARONIX M-1200 manufactured by Toagosei Co., Ltd.) was applied uniformly as a thin film with a thickness of 2 $\mu$m using a coating machine onto a polyester film having a thickness of 0.10 mm that had been subjected to a mold release treatment with fluorine, thereby forming a film 2.

<Film 3>

Epoxy acrylate (product name: 8101 manufactured by Japan U-PiCA Company, Ltd.) was applied uniformly as a thin film with a thickness of 2 $\mu$m using a coating machine onto a polyester film having a thickness of 0.10 mm that had been subjected to a mold release treatment with fluorine, thereby forming a film 3.

<Film 4>

Polyester acrylate (product name: M-8060 manufactured by Toagosei Co., Ltd.) was applied uniformly as a thin film with a thickness of 2 $\mu$m using a coating machine onto a polyester film having a thickness of 0.10 mm that had been subjected to a mold release treatment with fluorine, thereby forming a film 4.

<Film 5>

A solution in which 80 g (80 parts by mass) of urethane acrylate (product name: ARONIX M-1200 manufactured by Toagosei Co., Ltd.) and 20 g (20 parts by mass) of phenoxy acrylate (manufactured by OSAKA ORGANIC CHEMICAL INDUSTRY LTD.) were mixed homogeneously was applied uniformly as a thin film with a thickness of 2 $\mu$m using a coating machine onto a polyester film having a thickness of 0.10 mm that had been subjected to a mold release treatment with fluorine, thereby forming a film 5.

<Film 6>

A solution in which 80 g (80 parts by mass) of epoxy acrylate (product name: 8101 manufactured by Japan U-PiCA Company, Ltd.) and 20 g (20 parts by mass) of phenoxy acrylate (manufactured by OSAKA ORGANIC CHEMICAL INDUSTRY LTD.) were mixed homogeneously was applied uniformly as a thin film with a thickness of 2 $\mu$m using a coating machine onto a polyester film having a thickness of 0.10 mm that had been subjected to a mold release treatment with fluorine, thereby forming a film 6.

<Film 7>

A solution in which 80 g (80 parts by mass) of polyester acrylate (product name: M-8060 manufactured by Toagosei Co., Ltd.) and 20 g (20 parts by mass) of phenoxy acrylate (manufactured by OSAKA ORGANIC CHEMICAL INDUSTRY LTD.) were mixed homogeneously was applied uniformly as a thin film with a thickness of 2 $\mu$m using a coating machine onto a polyester film having a thickness of 0.10 mm that had been subjected to a mold release treatment with fluorine, thereby forming a film 7.

<Film 8>

A solution in which 80 g (80 parts by mass) of an acrylic polymer (product name: JDX-P1020 manufactured by JOHNSON POLYMER CORPORATION) and 20 g (20 parts by mass) of phenoxy acrylate (manufactured by OSAKA ORGANIC CHEMICAL INDUSTRY LTD.) were mixed homogeneously was applied uniformly as a thin film with a thickness

of 2 μm using a coating machine onto a polyester film having a thickness of 0.10 mm that had been subjected to a mold release treatment with fluorine, thereby forming a film 8.

<Film 9>

A solution in which 80 g (80 parts by mass) of an acrylic polymer (product name: JDX-P1020 manufactured by JOHNSON POLYMER CORPORATION) and 20 g (20 parts by mass) of urethane acrylate (product name: ARONIX M-1200 manufactured by manufactured by Toagosei Co., Ltd.) were mixed homogeneously was applied uniformly as a thin film with a thickness of 2 μm using a coating machine onto a polyester film having a thickness of 0.10 mm that had been subjected to a mold release treatment with fluorine, thereby forming a film 9.

<Release film >

A polyester film with a thickness of 0.10 mm that had been surface-treated with a fluorine compound was used as the release film.

Working Example 5

After placing the thermally conductive sheet base material on a sheet of the film 2, a sheet of the release film was placed on the sheet base material so as to form a sandwich structure. Thereafter, the whole structure was heated and pressure molded at 120°C for 30 minutes, followed by removing the top and bottom films, thereby forming sheets (A5) with thicknesses of 0.5 mm and 3.0 mm, on one side of which the cured thin film layer was formed integrally.

Working Example 6

After placing the thermally conductive sheet base material on a sheet of the film 3, a sheet of the release film was placed on the sheet base material so as to form a sandwich structure. Thereafter, the whole structure was heated and pressure molded at 120°C for 30 minutes, followed by removing the top and bottom films, thereby forming sheets (A6) with thicknesses of 0.5 mm and 3.0 mm, on one side of which the cured thin film layer was formed integrally.

Working Example 7

After placing the thermally conductive sheet base material on a sheet of the film 4, a sheet of the release film was placed on the sheet base material so as to form a sandwich structure. Thereafter, the whole structure was heated and pressure molded at 120°C for 30 minutes, followed by removing the top and bottom films, thereby forming sheets (A7) with thicknesses of 0.5 mm and 3.0 mm, on one side of which the cured thin film layer was formed integrally.

Working Example 8

After placing the thermally conductive sheet base material on a sheet of the film 5, a sheet of the release film was placed on the sheet base material so as to form a sandwich structure. Thereafter, the whole structure was heated and pressure molded at 120°C for 30 minutes, followed by removing the top and bottom films, thereby forming sheets (A8) with thicknesses of 0.5 mm and 3.0 mm, on one side of which the cured thin film layer was formed integrally.

Working Example 9

After placing the thermally conductive sheet base material on a sheet of the film 6, a sheet of the release film was placed on the sheet base material so as to form a sandwich structure. Thereafter, the whole structure was heated and pressure molded at 120°C for 30 minutes, followed by removing the top and bottom films, thereby forming sheets (A9) with thicknesses of 0.5 mm and 3.0 mm, on one side of which the cured thin film layer was formed integrally.

Working Example 10

After placing the thermally conductive sheet base material on a sheet of the film 7, a sheet of the release film was placed on the sheet base material so as to form a sandwich structure. Thereafter, the whole structure was heated and pressure molded at 120°C for 30 minutes, followed by removing the top and bottom films, thereby forming sheets (A10) with thicknesses of 0.5 mm and 3.0 mm, on one side of which the cured thin film layer was formed integrally.

Working Example 11

After placing the thermally conductive sheet base material on a sheet of the film 8, a sheet of the release film was placed on the sheet base material so as to form a sandwich structure. Thereafter, the whole structure was heated and pressure molded at 120°C for 30 minutes, followed by removing the top and bottom films, thereby forming sheets (A11) with thicknesses of 0.5 mm and 3.0 mm, on one side of which the cured thin film layer was formed integrally.

Working Example 12

After placing the thermally conductive sheet base material on a sheet of the film 9, a sheet of the release film was placed on the sheet base material so as to form a sandwich structure. Thereafter, the whole structure was heated and pressure molded at 120°C for 30 minutes, followed by removing the top and bottom films, thereby forming sheets (A12) with thicknesses of 0.5 mm and 3.0 mm, on one side of which the cured thin film layer was formed integrally.

Comparative Example 2

After placing the thermally conductive sheet base material on a sheet of the release film, a sheet of the same release film was placed on the sheet base material so as to form a sandwich structure. Thereafter, the whole structure was heated and pressure molded at 120°C for 30 minutes, thereby forming sheets (B2) with thicknesses of 0.5 mm and 3.0 mm.

Table 2 shows the results on the above-described sheets.

Table 2

| Sample No. | A5 | A6 | A7 | A8 | A9 | A10 | A11 | A12 | B2 |
|---|---|---|---|---|---|---|---|---|---|
| Hardness (Asker C) | 25 | 25 | 23 | 30 | 30 | 30 | 30 | 30 | 20 |
| Load (N) (Kgf) | 470.4 (48) | 441 (45) | 421.4 (43) | 490 (50) | 509.6 (52) | 509.6 (52) | 490 (50) | 499.8 (51) | 343 (35) |
| Elongation (mm) | 0.1 | 0.1 | 0.1 | 0 | 0 | 0 | 0 | 0 | 0.4 |
| Cracking | present | present | present | absent | absent | absent | absent | absent | absent |
| Thermal resistance value (°C/W) | 0.81 | 0.83 | 0.80 | 0.84 | 0.82 | 0.82 | 0.81 | 0.84 | 0.82 |

As is clearly seen from Table 2, the elongation of the sheets according to the working examples of the present invention at the time of removal from the release film could be reduced by forming the cured thin film layer integrally. Accordingly, it was possible to prevent deformation of the sheets.

Further, in the case of the sheets on which the cured thin film layer made of a material in which a modified acrylate was mixed with an acrylic monomer or an acrylic polymer at the ratio of 8:2 was formed integrally, the elongation of the sheets at the time removal from the release film was nearly "0", and the sheets did not crack when they were bent. This confirmed that these sheets had good handleability. Among them, the sample Nos. A9 to A12 of Working Examples 9 to 12 exhibited particularly high resistance to cracking when they were bent.

Furthermore, in the case of the sample Nos. A6 to A8 of Working Example 6 to Working Example 8, the cured thin film was formed only from a modified acrylate. Since a modified acrylate includes a large number of functional groups in its molecules, the cross-linking density of the cured thin film layer was higher and the cured thin film cracked easily. However, in the case of the sample Nos. A9 to A12 of Working Example 9 to Working Example 12, an acrylic monomer or an acrylic rubber was added to the modified acrylate to decrease the cross-linking density of the cured thin film layer, so that the cured thin film was imparted with flexibility and thus became more difficult to crack.

The sample No. B2 of Comparative Example 2 was an example in which the sample was formed only from the thermally conductive sheet base material. The sheet of the sample No. B2 of Comparative Example 2 was not desirable since it was elongated and deformed. In contrast, the sheets of the sample Nos. A9 to A12 of Working Example 9 to Working Example 12 deformed in the thickness direction, but not in the longitudinal direction, exhibiting good form stability. 3. Test-3 (Working Examples 13 to 20, Comparative Examples 3 and 4) (1) Formation of thermally conductive sheet base material

The thermally conductive sheet base material was formed in the same manner as Test-1.

(2) Film provided with thermally conductive, cured thin film layer

In order to carry out the tests by using a variety of materials for the thermally conductive, cured thin film layer that was formed integrally with the surface layer portion, film 11 to film 14 below were formed.

<Film 11>

To 100 g (100 parts by mass) of urethane acrylate (product name: ARONIX M-1200 manufactured by Toagosei Co., Ltd.), 200 g (200 parts by mass) of aluminum oxide (product name: AL-43L manufactured by SHOWA DENKO K.K.), 2 g (2 parts by mass) of iron black, 1 g (1 part by mass) of a curing agent (chemical name: t-Amyl peroxy-2-ethylhexanoate manufactured by Kayaku Akzo Corporation) were mixed sufficiently in a mixer. Then, the mixture was applied uniformly as a thin film with a thickness of 2 $\mu$m using a coating machine onto a polyester film having a thickness of 0.10 mm that had been subjected to a mold release treatment with fluorine, thereby forming a film 11.

<Film 12>

To 100 g (100 parts by mass) of polyester acrylate (product name: M-6100 manufactured by Toagosei Co., Ltd.), 200 g (200 parts by mass) of aluminum oxide (product name: AL-43L manufactured by SHOWA DENKO K.K.), 2 g (2 parts by mass) of iron black, 1 g (1 part by mass) of a curing agent (chemical name: t-Amyl peroxy-2-ethylhexanoate manufactured by Kayaku Akzo Corporation) were mixed sufficiently in a mixer. Then, the mixture was applied uniformly as a thin film with a thickness of 2 $\mu$m using a coating machine onto a polyester film having a thickness of 0.10 mm that had been subjected to a mold release treatment with fluorine, thereby forming a film 12.

<Film 13>

To 30 g (30 parts by mass) of an acrylic polymer (product name: JDX-P1020 manufactured by JOHNSON POLYMER CORPORATION) and 70 g (70 parts by mass) of urethane acrylate (product name: ARONIX M-1100 manufactured by Toagosei Co., Ltd.), 200 g (200 parts by mass) of aluminum oxide (product name: AL-43L manufactured by SHOWA DENKO K.K.), 2 g (2 parts by mass) of iron black, and 1 g (1 part by mass) of a curing agent (chemical name: t-Amyl peroxy-2-ethylhexanoate manufactured by Kayaku Akzo Corporation) were mixed sufficiently in a mixer. Then, the mixture was applied uniformly as a thin film with a thickness of 2 $\mu$m using a coating machine onto a polyester film having a thickness of 0.10 mm that had been subjected to a mold release treatment with fluorine, thereby forming a film 13.

<Film 14>

To 30 g (30 parts by mass) of an acrylic polymer (product name: JDX-P1020 manufactured by JOHNSON POLYMER CORPORATION) and 70 g (70 parts by mass) of polyester acrylate (product name: M-6100 manufactured by Toagosei Co., Ltd.), 200 g (200 parts by mass) of aluminum oxide (product name: AL-43L manufactured by SHOWA DENKO K.K.), 2 g (2 parts by mass) of iron black, and 1 g (1 part by mass) of a curing agent (chemical name: t-Amyl peroxy-2-ethylhexanoate manufactured by Kayaku Akzo Corporation) were mixed sufficiently in a mixer. Then, the mixture was applied uniformly as a thin film with a thickness of 2 $\mu$m using a coating machine onto a polyester film having a thickness of 0.10 mm that had been subjected to a mold release treatment with fluorine, thereby forming a film 14.

<Film 15>

A polyester film having a thickness of 0.10 mm that had been surface-treated with a fluorine compound was used as a film 15.

<Formation of sheet-like reinforcing material>

The sheet-like reinforcing material was formed by cutting a polyester fiber mesh (product name: C33 A2-100E11 with a thickness of 0.16 mm, manufactured by UNITIKA GLASS FIBER CO., LTD.) into a predetermined size in such a manner that no grease or dirt would adhere onto the surface of the mesh.

<Release film>

A polyester film having a thickness of 0.10 mm that had been surface-treated with a fluorine compound was used as the release film.

Working Example 13

After placing the sheet-like reinforcing material on a sheet of the film 11, the thermally conductive sheet base material was placed on the reinforcing material, and a sheet of the release film was placed further on the sheet base material so as to form a sandwich structure. Thereafter, the whole structure was heated and pressure molded at 120°C for 30 minutes, followed by removing the top and bottom films, thereby forming sheets (A13) with thicknesses of 0.5 mm and 3.0 mm, on one side of which the thermally conductive, cured thin film layer was formed integrally.

Working Example 14

After placing the thermally conductive sheet base material on a sheet of the film 11, a sheet of the release film was placed on the sheet base material so as to form a sandwich structure. Thereafter, the whole structure was heated and pressure molded at 120°C for 30 minutes, followed by removing the top and bottom films, thereby forming sheets (A14) with thicknesses of 0.5 mm and 3.0 mm, on one side of which the thermally conductive, cured thin film layer was formed integrally.

Working Example 15

After placing the sheet-like reinforcing material on a sheet of the film 12, the thermally conductive sheet base material was placed on the reinforcing material, and a sheet of the release film was placed further on the sheet base material so as to form a sandwich structure. Thereafter, the whole structure was heated and pressure molded at 120°C for 30 minutes, followed by removing the top and bottom films, thereby forming sheets (A15) with thicknesses of 0.5 mm and 3.0 mm, on one side of which the thermally conductive, cured thin film layer was formed integrally.

Working Example 16

After placing the thermally conductive sheet base material on a sheet of the film 12, a sheet of the release film was placed on the sheet base material so as to form a sandwich structure. Thereafter, the whole structure was heated and pressure molded at 120°C for 30 minutes, followed by removing the top and bottom films, thereby forming sheets (A16) with thicknesses of 0.5 mm and 3.0 mm, on one side of which the thermally conductive, cured thin film layer was formed integrally.

Working Example 17

After placing the sheet-like reinforcing material on a sheet of the film 13, the thermally conductive sheet base material was placed on the reinforcing material, and a sheet of the release film was placed further on the sheet base material so as to form a sandwich structure. Thereafter, the whole structure was heated and pressure molded at 120°C for 30 minutes, followed by removing the top and bottom films, thereby forming sheets (A17) with thicknesses of 0.5 mm and 3.0 mm, on one side of which the thermally conductive, cured thin film layer was formed integrally.

Working Example 18

After placing the thermally conductive sheet base material on a sheet of the film 13, a sheet of the release film was placed on the sheet base material so as to form a sandwich structure. Thereafter, the whole structure was heated and pressure molded at 120°C for 30 minutes, followed by removing the top and bottom films, thereby forming sheets (A18) with thicknesses of 0.5 mm and 3.0 mm, on one side of which the thermally conductive, cured thin film layer was formed integrally.

Working Example 19

After placing the sheet-like reinforcing material on a sheet of the film 14, the thermally conductive sheet base material was placed on the reinforcing material, and a sheet of the release film was placed further on the sheet base material so as to form a sandwich structure. Thereafter, the whole structure was heated and pressure molded at 120°C for 30 minutes, followed by removing the top and bottom films, thereby forming sheets (A19) with thicknesses of 0.5 mm and 3.0 mm, on one side of which the thermally conductive, cured thin film layer was formed integrally.

Working Example 20

After placing the thermally conductive sheet base material on a sheet of the film 14, a sheet of the release film was placed on the sheet base material so as to form a sandwich structure. Thereafter, the whole structure was heated and pressure molded at 120°C for 30 minutes, followed by removing the top and bottom films, thereby forming sheets (A20) with thicknesses of 0.5 mm and 3.0 mm, on one side of which the thermally conductive, cured thin film layer was formed integrally.

Comparative Example 3

After placing the sheet-like reinforcing material on a sheet of the film 15, the thermally conductive sheet base material was placed on the reinforcing material, and a sheet of the release film was placed further on the sheet base material so as to form a sandwich structure. Thereafter, the whole structure was heated and pressure molded at 120°C for 30 minutes, followed by removing the top and bottom films, thereby forming sheets (B3) with thicknesses of 0.5 mm and 3.0 mm.

Comparative Example 4

After placing the thermally conductive sheet base material on a sheet of the film 15, a sheet of the release film was placed on the sheet base material so as to form a sandwich structure. Thereafter, the whole structure was heated and pressure molded at 120°C for 30 minutes, followed by removing the top and bottom films, thereby forming sheets (B4) with thicknesses of 0.5 mm and 3.0 mm.

Comparative Example 5

After placing the thermally conductive sheet base material on a sheet of the release film, a sheet of the release film was placed further on the sheet base material so as to form a sandwich structure. Thereafter, the whole structure was heated and pressure molded at 120°C for 30 minutes, followed by removing the top and bottom films, thereby forming sheets (B5) with thicknesses of 0.5 mm and 3.0 mm.

Comparative Example 6

10 g (10 parts by mass) of an acrylic polymer (product name: JDX-P1020 manufactured by JOHNSON POLYMER CORPORATION) and 90 g (90 parts by mass) of ester acrylate (product name: ARONIX M-8530 manufactured by Toagosei Co., Ltd.) were kneaded in a mixer, together with 1.0 g (1.0 part by mass) of a curing agent (chemical name: t-Amyl peroxy-2-ethylhexanoate manufactured by Kayaku Akzo Corporation). After a sheet of the release film was placed on both sides of the mixture so as to form a sandwich structure, the whole structure was heated and pressure molded at 120°C for 30 minutes, followed by removing the top and bottom films, thereby forming sheets (B6) with thicknesses of 0.5 mm and 3.0 mm.

Tables 3 and 4 show the results on the above-described sheets.

Table 3

| Sample No. | A13 | A14 | A15 | A16 | A17 | A18 | A19 | A20 |
|---|---|---|---|---|---|---|---|---|
| Sheet-like reinforcing material | provided | not provided | provided | not provided | provided | not provided | provided | not provided |
| Adhesive strength (g/25 mm) | 0 | 0 | 0 | 0 | 0 | 0 | 0 | 0 |
| Thermal resistance value (°C/W) | 0.92 | 0.99 | 0.92 | 0.88 | 0.90 | 0.86 | 0.90 | 0.86 |

(continued)

| Sample No. | A13 | A14 | A15 | A16 | A17 | A18 | A19 | A20 |
|---|---|---|---|---|---|---|---|---|
| Removability | easy | easy | easy | easy | easy | easy | easy | easy |

Table 4

| Sample No. | B3 | B4 | B5 | B6 |
|---|---|---|---|---|
| Sheet-like reinforcing material | provided | not provided | provided | not provided |
| Adhesive strength (g/25 mm) | 12 | 12 | 0 | 0 |
| Thermal resistance value (°C/W) | 0.38 | 0.36 | 0.94 | 0.92 |
| Removability | difficult | difficult | easy | easy |

As is clearly seen from Tables 3 and 4, the adhesive strength of the sample Nos. A13 to 20 of Working Examples 13 to 20 could be reduced to nearly "0" by forming the cured thin film layer. This made it possible to separate a heat-generating electronic component and a radiator readily, even after inserting the thermally conductive film between them. Furthermore, the thermal resistance value (°C/W) was improved even further by providing the cured thin film layer with thermal conductivity.

**Claims**

1. A thermally conductive sheet comprising, as a main component, an acrylic polymer into which a thermally conductive filler is mixed,
   wherein an inner layer or one side of the sheet is a solventless, adhesive elastic product, and
   a cured thin film layer is formed integrally with a surface layer portion on at least one selected from top and bottom surfaces of the sheet, and a sheet-like reinforcing material is further embedded in the surface layer portion on said one of the top and bottom surfaces of the sheet, **characterized in that**:

   the thermally conductive sheet has a thickness in the range from 0.10 to 10 mm, and
   the cured thin film layer has a thickness in the range from 0.001 to 0.50 mm, and a portion of the sheet that constitutes the inner layer or one side has a viscosity in the range from $1 \times 10$ to $3 \times 10^3$ Pa. s ($1 \times 10^4$ to $3 \times 10^6$ cP), and in the thermally conductive sheet, the thermally conductive filler in the range from 50 to 3000 g (50 to 3000 parts by mass) per 100 g (100 parts by mass) of the acrylic polymer is mixed, and the thermally conductive sheet has a thermal conductivity of 0.5 to 5.0 W/m K, and
   the thermally conductive, cured thin film layer has a thermal conductivity of 0.20 to 2.5 W/m K, and
   the main component acrylic polymer into which the thermally conductive filler is mixed has an ASKER C hardness in the range from 5 to 95, after curing the sheet, and the sheet-like reinforcing material is embedded at a depth in the range from more than 0 mm to 1.00 mm from the surface, and the sheet has a thickness of 0.10 mm to 10.0 mm.

2. The thermally conductive sheet according to claim 1,
   wherein the sheet-like reinforcing material is a mesh structure that is formed from at least one selected from synthetic fiber and natural fiber.

3. A method for producing a thermally conductive sheet comprising, as a main component, an acrylic polymer into which a thermally conductive filler is mixed, the method comprising the steps of:

   forming a cured thin film material layer wherein a material for a thermally conductive, cured thin film layer is applied uniformly as a thin film onto a surface of at least one selected from a top release film and a bottom release film;
   providing, when one of the films includes the cured thin film material layer, a release film as the other film;
   supplying, between the top film and the bottom film, a sheet base material comprising, as a main component, an acrylic polymer into which a thermally conductive filler is mixed, and molding the sheet base material into a sheet having a predetermined thickness; and

thereafter curing only a surface layer portion of the sheet and then removing the films, thereby producing the thermally conductive sheet according to any of claims 1 to 2 wherein an inner layer or one side of the sheet is a solventless, adhesive elastic product, and a cured thin film layer is formed integrally with a surface layer portion on at least one selected from the top and bottom surfaces of the sheet.

## Patentansprüche

1. Wärmeleitfähige Folie, die als eine Hauptkomponente ein Acrylpolymer enthält, in das ein wärmeleitfähiger Füllstoff eingemischt ist,

wobei eine innere Schicht oder eine Seite der Folie ein lösemittelfreies, klebendes, elastisches Produkt ist, und eine ausgehärtete dünne Filmschicht integral mit einem Oberflächenschichtabschnitt auf mindestens einer von einer Ober- und einer Unterseite der Folie ausgebildet ist, und des Weiteren ein bahnartiges Verstärkungsmaterial in den Oberflächenschichtabschnitt auf der einen der Ober- und der Unterseite der Folie eingebettet ist, **dadurch gekennzeichnet, dass**:

die wärmeleitfähige Folie eine Dicke im Bereich von 0,10 bis 10 mm aufweist und

die ausgehärtete Filmschicht eine Dicke im Bereich von 0,001 bis 0,50 mm hat und ein Abschnitt der Folie, der die innere Schicht oder eine Seite darstellt, eine Viskosität im Bereich von $1 \times 10$ bis $3 \times 10^3$ Pa. s ($1 \times 10^4$ bis $3 \times 10^6$ cP) aufweist und in der wärmeleitfähigen Folie der wärmeleitfähige Füllstoff im Bereich von 50 bis 3000 g (50 bis 3000 Masseteile) pro 100 g (100 Masseteile) des Acrylpolymers eingemischt ist und die wärmeleitfähige Folie eine Wärmeleitfähigkeit von 0,5 bis 5,0 W/m K aufweist und die wärmeleitfähige, ausgehärtete dünne Filmschicht eine Wärmeleitfähigkeit von 0,20 bis 2,5 W/m K aufweist und

die Hauptkomponente Acrylpolymer, in die der wärmeleitfähige Füllstoff eingemischt ist, eine ASKER C-Härte im Bereich von 5 bis 95 nach dem Aushärten der Folie aufweist und das bahnartige Verstärkungsmaterial in einer Tiefe im Bereich von mehr als 0 mm bis 1,00 mm von der Oberfläche aus eingebettet ist und die Folie eine Dicke von 0,10 mm bis 10,0 mm aufweist.

2. Wärmeleitfähige Folie nach Anspruch 1, wobei das bahnartige Verstärkungsmaterial eine Maschenstruktur ist, die aus mindestens einem aus der Gruppe bestehend aus Kunstfasern und Naturfasern ausgewählt ist.

3. Verfahren zum Herstellen einer wärmeleitfähigen Folie, die als eine Hauptkomponente ein Acrylpolymer enthält, in das ein wärmeleitfähiger Füllstoff eingemischt ist, wobei das Verfahren folgende Schritte umfasst:

Bilden einer ausgehärteten dünnen Folienmaterialschicht, wobei ein Material für eine wärmeleitfähige, ausgehärtete dünne Filmschicht gleichmäßig als ein dünner Film auf eine Oberfläche von mindestens einem von einem oberen Trennfilm und einem unteren Trennfilm aufgebracht wird;

Bereitstellen, wenn einer der Filme die ausgehärtete dünne Folienmaterialschicht enthält, eines Trennfilms als den anderen Film;

Anordnen, zwischen dem oberen Film und dem unteren Film, eines Folienbasismaterials, das als eine Hauptkomponente ein Acrylpolymer enthält, in das ein wärmeleitfähiger Füllstoff eingemischt ist, und Formen des Folienbasismaterials zu einer Folie mit einer vorgegebenen Dicke; und

anschließendes Aushärten nur eines Oberflächenschichtabschnitts der Folie und dann Entfernen der Filme, wodurch

die wärmeleitfähige Folie nach einem der Ansprüche 1 bis 2 entsteht, wobei eine innere Schicht oder eine Seite der Folie ein lösemittelfreies, klebendes, elastisches Produkt ist, und eine ausgehärtete dünne Filmschicht integral mit einem Oberflächenschichtabschnitt auf mindestens einem von der Ober- und der Unterseite der Folie ausgebildet wird.

## Revendications

1. Feuille thermoconductrice comprenant, en tant que composant principal, un polymère acrylique dans lequel une charge thermoconductrice est mélangée,

dans lequel une couche interne ou un côté de la feuille est un produit élastique adhésif sans solvant, et une couche de film mince durcie est formée d'une seule pièce avec une partie de couche de surface sur au moins une surface sélectionnée parmi les surfaces supérieure et inférieure de la feuille, et un matériau de renforcement en forme de feuille est en outre incorporé dans la partie de couche de surface de ladite une surface des surfaces supérieure et inférieure de la feuille, **caractérisée en ce que** : la feuille thermoconductrice a une épaisseur dans la plage de 0,10 à 10 mm, et

la couche de film mince durcie a une épaisseur dans la plage de 0,001 à 0,50 mm et une partie de la feuille qui constitue la couche interne ou un côté a une viscosité dans la plage de 1 x 10 à 3 x $10^3$ Pa.s (1 x $10^4$ à 3 x $10^6$ cP), et dans la feuille thermoconductrice, la charge thermoconductrice dans la plage de 50 à 3000 g (50 à 3000 parties en masse) pour 100 g (100 parties en masse) du polymère acrylique est mélangée, et la feuille thermoconductrice a une conductivité thermique de 0,5 à 5,0 W/m K, et la couche de film mince durcie thermoconductrice a une conductivité thermique de 0,20 à 2,5 W/m K, et

le composant principal de polymère acrylique dans lequel la charge thermoconductrice est mélangée présente une dureté ASKER C comprise entre 5 et 95, après durcissement de la feuille, et le matériau de renforcement en forme de feuille est incorporé à une profondeur allant de plus de 0 mm à 1,00 mm de la surface, et la feuille a une épaisseur de 0,10 mm à 10,0 mm.

2. Feuille thermoconductrice selon la revendication 1,
   dans laquelle le matériau de renforcement en forme de feuille est une structure à mailles qui est formée à partir d'au moins un élément choisi parmi les fibres synthétiques et les fibres naturelles.

3. Procédé de production d'une feuille thermoconductrice comprenant, en tant que composant principal, un polymère acrylique dans lequel une charge thermoconductrice est mélangée, le procédé comprenant les étapes consistant à :

   former une couche de matériau de film mince durcie, dans lequel un matériau pour une couche de film mince durcie thermoconductrice est appliqué de manière uniforme en tant que film mince sur une surface d'au moins un film sélectionné parmi un film antiadhésif supérieur et un film antiadhésif inférieur ;

   fournir, lorsque l'un des films comprend la couche de matériau de film mince durcie, un film antiadhésif en tant qu'autre film ;

   fournir, entre le film supérieur et le film inférieur, un matériau de base de feuille comprenant, en tant que composant principal, un polymère acrylique dans lequel une charge thermoconductrice est mélangée, et mouler le matériau de base de feuille en une feuille ayant une épaisseur prédéterminée ; et

   durcir ensuite seulement une partie de couche superficielle de la feuille, puis retirer les films, et ainsi produire la feuille thermoconductrice selon l'une quelconque des revendications 1 à 2, dans lequel une couche interne ou un côté de la feuille est un produit élastique adhésif sans solvant, et une couche de film mince durcie est formée d'une seule pièce avec une partie de couche de surface sur au moins une surface sélectionnée parmi les surfaces supérieure et inférieure de la feuille.

FIG. 1A

FIG. 1B

FIG. 2A

FIG. 2B

FIG. 3

FIG. 4

**EP 1 641 040 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9207275 A
- JP H10183110 A
- US 6644395 B
- US 6090484 A
- US 6657297 B